# Europäisches Patentamt

## European Patent Office

### Office européen des brevets

(19)

(11) EP 0 531 768 B1

(12) **EUROPÄISCHE PATENTSCHRIFT**

(45) Veröffentlichungstag und Bekanntmachung des Hinweises auf die Patenterteilung:
**13.03.1996 Patentblatt 1996/11**

(51) Int Cl.6: **H01S 3/25**, H01S 3/025, G02F 1/225, H04J 14/02

(21) Anmeldenummer: **92114204.8**

(22) Anmeldetag: **20.08.1992**

(54) **Verfahren zum Betreiben eines Halbleiterbauelements als optisches Filter**

Method for operating a semi-conductor device as an optical filter

Méthode de fonctionnement d'un dispositif à semi-conducteur comme filtre optique

(84) Benannte Vertragsstaaten:
**BE DE ES FR GB IT NL**

(30) Priorität: **10.09.1991 DE 4130047**

(43) Veröffentlichungstag der Anmeldung:
**17.03.1993 Patentblatt 1993/11**

(73) Patentinhaber:
- **Alcatel SEL Aktiengesellschaft**
  **D-70435 Stuttgart (DE)**
  Benannte Vertragsstaaten:
  **DE**
- **ALCATEL N.V.**
  **NL-1077 XX Amsterdam (NL)**
  Benannte Vertragsstaaten:
  **BE ES FR GB IT NL**

(72) Erfinder:
- **Idler, Wilfried**
  **W-7145 Markgröningen (DE)**
- **Laube, Gert, Dr.**
  **W-7000 Stuttgart 40 (DE)**
- **Schilling, Michael**
  **W-7000 Stuttgart 31 (DE)**
- **Wünstel, Klaus, Dr.**
  **W-7141 Schwieberdingen (DE)**
- **Baums, Dieter, Dr.**
  **W-7140 Ludwigsburg (DE)**
- **Hildebrand, Olaf, Dr.**
  **W-7000 Stuttgart 61 (DE)**
- **Dütting, Kaspar**
  **W-7000 Stuttgart 31 (DE)**

(74) Vertreter: **Pechhold, Eberhard, Dipl.-Phys. et al**
**Alcatel SEL AG**
**Patent- und Lizenzwesen**
**Postfach 30 09 29**
**D-70449 Stuttgart (DE)**

(56) Entgegenhaltungen:
- **IEEE JOURNAL OF QUANTUM ELECTRONICS. Bd. 27, Nr. 6, Juni 1991, NEW YORK US Seiten 1616 - 1624 M. SCHILLING ET AL. 'Integrated interferometric injection laser: novel fast and broad-band tunable monolithic light source'**
- **PATENT ABSTRACTS OF JAPAN vol. 13, no. 508 (P-960) 15. November 1989 & JP-A-12 06 313 ( FUJITSU LDT. )**
- **APPLIED PHYSICS LETTERS. Bd. 54, Nr. 19, 8. Mai 1989, NEW YORK US Seiten 1859 - 1860 T. NUMAI ET AL. '1.5 mum tunable wavelength filter using a phase-shift-controlled distributed feedback laser diode with a wide tuning range and a high constant gain'**
- **Transactions of the I.E.C.E. of Japan, Bd. C-69, Nr. 4, April 1986, Seiten 392- 394**
- **Patent Abstracts of Japan, Bd. 6, Nr. 195 (P-146) [1073] 05.10.1982 &JP-A-57 104 902**
- **Patent Abstracts of Japan, Bd. 9, Nr. 118 (E-316) 23.05.1985 &JP-A-60 009 189**
- **Electronics Letters, Bd. 26, Nr. 4, Februar 1990, Seiten 243-244**

**Beschreibung**

Die Erfindung bezieht sich auf ein Verfahren zum Betreiben eines Halbleiterbauelements als optisches Filter, nach dem Oberbegriff des Patentanspruchs 1.

Aus Electronics Letters 24 (1990), Seiten 243 bis 244 ist ein Halbleiterbauelement bekannt, das dort als interferometrischer Halbleiterlaser betrieben wird. Das Halbleiterbauelement ist auf einem n-dotierten Indiumphosphid-Substrat monolithisch integriert. Oberhalb des Indiumphosphid-Substrats erstreckt sich eine ebenfalls n-dotierte Pufferschicht aus Indiumphosphid. Auf deren ebener Oberfläche liegt eine Wellenleiterschicht aus Indium-Gallium-Arsenid--Phosphid (InGaAsP). Die Wellenleiterschicht besitzt die Form eines "Y". Oberhalb der Wellenleiterschicht sind weitere Schichten vorhanden. Diese und die Wellenleiterschicht bilden oberhalb der Pufferschicht eine "Y"-förmige Mesa.

Oberhalb der Wellenleiterschicht ist die Oberfläche des Halbleiterlasers mit einer Metallschicht bedeckt, die durch drei Gräben aufgetrennt ist, wodurch 4 Bereiche entstehen, in die der Halbleiterlaser aufgeteilt ist. Die Wellenleiterschicht erstreckt sich über alle Bereiche. An die Metallschicht läßt sich in jedem Bereich ein Strom anlegen, der durch die Wellenleiterschicht hindurch zu einer einen Massekontakt bildenden Metallschicht auf der Unterseite des Subtrats abfließt.

Wenn der Strom in einem der Bereiche eine bestimmte Schwelle, den Transparenzstrom, überschreitet, wird die Wellenleiterschicht in dem jeweiligen Bereich "transparent", d.h. lichtdurchlässig. Bei weiterem Ansteigen des Stromes wird der Laserschwellstrom des jeweiligen Bereichs überschritten, d.h. die Wellenleiterschicht wird in diesem Bereich laseraktiv und erzeugt kohärentes Licht.

Aus J. Appl. Phys. 34 (1963), Seiten 2997 bis 3003, ist es bekannt, die Linienbreite und die Voraussetzungen für den kontinuierlichen Betrieb von Mehrsegmentlasern zu bestimmen. Diese werden ausgehend von den Randbedingungen eines Fabry-Pérot-Resonators diskutiert.

Es ist Aufgabe der Erfindung, ein Verfahren zu schaffen, durch das Licht, das von außen in einen der auf dem Halbleiterbauelement vorhandenen Bereiche eingestrahlt wird, gefiltert wird.

Die Aufgabe wird, wie in Patentanspruch 1 angegeben, gelöst.

Ein Vorteil dieses Verfahrens besteht darin, daß, infolge Ausnutzung des sogenannten Mach-Zehnder-Effektes, sich die Filterfrequenz in einem breiten Bandbereich beeinflussen läßt, indem die Ströme, die durch die Bereiche fließen, geändert werden. Dieser Vorteil läßt sich besonders für die optische Übertragung ausnutzen, in der beispielsweise für den Wellenlängen-Multiplex-Betrieb bestimmte Wellenlängenkanäle ausgewählt werden sollen.

Eine vorteilhafte Weiterbildung des Verfahrens ergibt sich aus Anspruch 2.

Danach ist es besonders vorteilhaft, wenn durch einen Bereich, der in Übertragungsrichtung hinter dem Verzweigungsbereich angeordnet ist, ein Strom in Sperrrichtung fließt, um Lichtsignale zu detektieren. Eine dadurch erfolgende Schwächung des Lichtsignals läßt sich in anderen Bereichen, die als optische Verstärker wirken, kompensieren.

Nachfolgend wird die Erfindung anhand der Zeichnungen in Ausführungsbeispielen beschrieben. Es zeigen:

Fig. 1   den Aufbau des Halbleiterbauelements zur Durchführung des Verfahrens und

Fig. 2   die Intensität des aus der Wellenleiterschicht des Halbleiterbauelements herauskommenden Lichts als Funktion der Phase $\delta$.

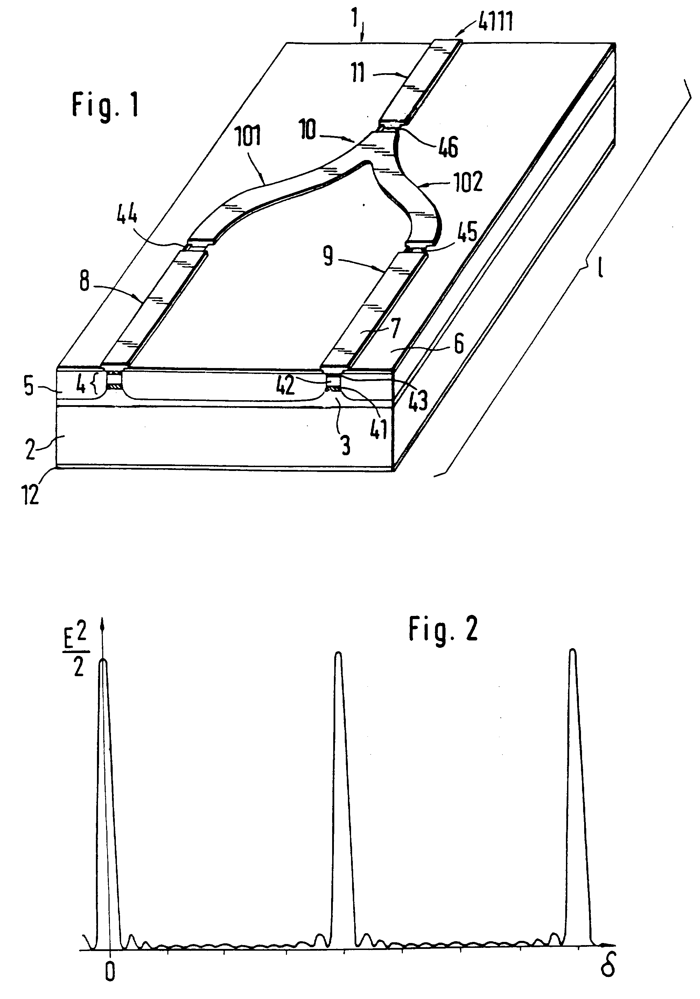

In Fig. 1 ist ein Halbleiterbauelement 1 dargestellt. Es weist ein Substrat 2 aus n-dotiertem Indiumphosphid auf. Darüber liegt eine Pufferschicht 3, die ebenfalls aus n-dotiertem Indiumphosphid besteht und von der ein Teil die unterste Schicht einer Mesa 4 bildet, die die Form eines "Y" hat. Die Mesa 4 weist mehrere Schichten auf. Sie enthält eine Wellenleiterschicht 41 aus Indium-Gallium-Arsenid-Phosphid. Diese wird von einer Mantelschicht 42 aus p-dotiertem Indiumphosphid bedeckt. Darüber liegt eine Kontaktschicht 43 aus p+-dotiertem Indium-Gallium-Arsenid.

Seitlich der Mesa 4 und oberhalb der nicht durch die Schicht 41 bedeckten Oberfläche der Pufferschicht 3 ist zur optischen Wellenführung in der Mesa 4 eine Schicht 5 aus semiisolierendem Indiumphosphid vorhanden, deren obere Oberfläche mit der oberen Oberfläche der Kontaktschicht 43 eine Ebene bildet. Die Schicht 5 ist mit einer Schutzschicht 6 aus Siliziumdioxid bedeckt, die Kontaktschicht 43 mit einer Metallschicht 7.

In der Metallschicht 7 und der Mesa 4 sind drei Gräben 44, 45, 46 vorhanden, durch die die Mesa 4 in einen ersten Bereich 8, einen zweiten Bereich 11, einen dritten Bereich 9 und einen Verzweigungsbereich 10 eingeteilt wird. Gemäß der Darstellung in Fig. 1 dürfen die Gräben 44, 45, 46 entsprechend der optischen Kopplung, die die Bereiche 8, 9, 11 sowie der Verzweigungsbereich 10 untereinander haben sollen, bis in die Mantelschicht 42, jedoch nicht in die Wellenleiterschicht 41 herabreichen. Die Metallschicht 7 bildet in jedem Bereich 8, 9, 11 und in dem Verzweigungsbereich 10 je eine erste Elektrode. Eine zweite Elektrode wird für jeden Bereich 8, 9, 11 und den Verzweigungsbereich 10 durch eine Metallschicht 12 gebildet, die auf die Unterseite des Substrats 2 aufgebracht ist. Von der Metallschicht 7 fließt beim Betrieb des Halbleiterbauelements 1 durch jeden Bereich 8, 9, 11 und den Verzweigungsbereich 10 ein jeweils einzeln fest einstellbarer oder veränderbarer Strom zu der Metallschicht 12, die als Massekontakt dient.

Durch die Bereiche 8, 9 und 11 sowie durch den Verzweigungsbereich 10 fließen jeweils Ströme, die kleiner sind als die jeweiligen Laserschwellströme.

Vorzugsweise in den Bereich 11 wird an seinem freien Ende Licht eingestrahlt, aus dem eine bestimmte Wellenlänge herausgefiltert werden soll. Bei dem Licht handelt es sich beispielsweise um Lichtsignale im Wellenlängen-Multiplex von z.B. vier Wellenlängen, aus denen eine Wellenlänge herausgefiltert werden soll.

Das Halbleiterbauelement 1 wirkt als Fabry-Pérot-Resonator mit zwei Armen, gebildet durch die Bereiche 8 und 9.

Die Wellenleiterschicht 41 läßt sich auffassen als die Überlagerung zweier Fabry-Pérot-Resonatoren. Ein erster Fabry-Pérot-Resonator wird durch die Bereiche 11 und 8 und einen sie miteinander verbindenden Zweig 101 des Verzweigungsbereiches 10 gebildet, ein zweiter Fabry-Pérot-Resonator durch die Bereiche 11 und 9 und einem sie verbindenden Zweig 102 des Verzweigungsbereiches 10. Dementsprechend hat das Halbleiterbauelement ein Filterspektrum, das der Überlagerung der Spektren zweier geringfügig gegeneinander verstimmter Fabry-Pérot-Resonatoren entspricht. Die Intensität $I = E^2/2$ weist, als Funktion der Phase $\delta$ aufgetragen, in großen Abständen große Maxima und in kleinen Abständen niedrige Maxima auf. Diese Maxima entsprechen einer Grob- und einer Feinstruktur von Resonanzen in der Wellenleiterschicht 41.

Die Bereiche 8, 9 beeinflussen entsprechend ihrer Länge $l_8$, $l_9$ und dem Brechungsindex $n_8$, $n_9$, wie er sich aufgrund des jeweils durch sie hindurchfließenden Stroms ergibt, den Abstand $\Delta f_1$ zwischen den der Feinstruktur zuzuschreibenden optischen Resonanzen (Maxima).

Es gilt:

$$\Delta f_1 = \frac{c/2}{2l_{11} + l_8 + l_9},$$

wenn die Länge des Verzweigungsbereichs 10 vernachlässigt oder bei den Längen der Bereiche 8, 9, 11 mitberücksichtigt wird.

Für ein 1,5 mm langes Halbleiterbauelement mit einer Wellenleiterschicht 41 aus Indium-Gallium-Arsenid-Phosphid bedeutet dies:

$$\Delta f_1 = 14 \text{ GHz.}$$

Der Abstand $\Delta f_s$ zwischen der Grobstruktur zuzuordnenden optischen Resonanzen beträgt:

$$\Delta f_s = \frac{C}{l_8 - l_9}$$

Wenn sich nun ein optischer Weglängenunterschied zwischen der Länge $l_8$ des Bereichs 8 und der Länge $l_9$ des Bereichs 9 ergibt, der ausschließlich auf dem Unterschied der Brechungs indices $n_8$ und $n_9$ beruht, und durch eine unterschiedliche Stärke der Ströme $l_8$ und $l_9$, die durch die Bereiche fließen, hervorgerufen wird, gilt beispielsweise bei $l_9 - l_8 = 100$ mA

$$\Delta f_s \approx 86 \text{ THz,}$$

$$\frac{\Delta f_s}{\Delta f_1} \approx 6143,$$

d.h. in einer Darstellung der Intensität als Funktion der Frequenz fallen zwischen zwei große Maxima der Grobstruktur 6143 niedrige Feinstruktur-Maxima. Dabei wird angenommen, daß der Stromdifferenz 100 mA eine Weglängendifferenz von 7 µm entspricht. Durch geeignete Wahl der Differenz der Ströme $l_8$ und $l_9$ läßt sich eine starke Unterdrückung der Feinstruktur-Resonanzen zugunsten der Grobstruktur-Resonanzen erreichen.

In einem anderen, hier nicht dargestellten Ausführungsbeispiel ist mindestens einer der Bereiche 8 und 9 durch einen Graben, der die Form der Gräben 44, 45, 46 hat, in zwei Teilbereiche unterteilt, wobei durch den einen Teilbereich, wie durch die jeweils anderen Bereiche und den Verzweigungsbereich 10 ein Strom in Durchlaßrichtung fließt, während durch den anderen Teilbereich ein Strom in Sperrichtung fließt. Dieser Teilbereich dient dann als Photodiode, in der ein Teil des Lichts absorbiert und für Detektionszwecke verwendet werden kann.

Der durchgelassene Anteil des Lichts, das in die Wellenleiterschicht 41 von außen eingestrahlt wird, läßt sich auch dadurch beeinflussen, daß die Bereiche 8, 9 und 11 an ihren mit den Endflächen des Halbleiterbauelements 1 zusammenfallenden freien Endflächen mit einer dünnen Schicht oder mehreren dünnen Schichten aus einem Dielektrikum, z.B. Siliziumnitrid, Siliziumdioxid oder Siliziumoxinitrid, beschichtet sind.

**Patentansprüche**

1. Verfahren zum Betreiben eines interferometrischen Halbleiterbauelementes (1) als optisches Filter, wobei das Halbleiterbauelement eine auf einem Substrat (2) monolithisch integrierte, durchgehende Wellenleiterschicht (41) aufweist, die, zusammen mit weiteren Schichten (3, 42, 43), eine Mesa (4) bildet, eine verzweigte, einfach zusammenhängende, y-förmige Struktur besitzt und durch Gräben (44, 45, 46) in einer der Mesa aufliegenden Metallschicht (7) in voneinander getrennte Bereiche (8, 9, 10, 11) unterteilt ist, von denen einer ein dreiarmiger Verzweigungsbereich (10) ist an dessen Arme sich die übrigen Bereiche (8,9,11) auschließen, **dadurch gekennzeichnet**, daß zu filterndes Licht durch eine Endfläche (4111) eines der Bereiche, parallel zur Substratoberfläche in diesen Bereich eingestrahlt wird und daß in die einzelnen Bereiche einschließlich des Verzweigungsbereichs über deren aufliegende Metallschicht (7) Ströme eingespeist werden, die die Bereiche senkrecht zur Ausbreitungsrichtung des Lichtes durchfließen und kleiner sind als der Laserschwellstrom des jeweiligen Bereichs.

**2.** Verfahren nach Anspruch 2, dadurch gekennzeichnet, daß durch mindestens einen der Bereiche (8, 9, 11) ein Strom in Sperrichtung fließt.

## Claims

**1.** A process for the operation of an interferometric semiconductor component (1) as an optical filter, where the semiconductor component comprises a continuous waveguide layer (41) which is monolithically integrated on a substrate (2) and which, together with further layers (3, 42, 43), forms a mesa (4), possesses a branched, simply connected y-shaped structure, and is subdivided by trenches (44, 45, 46) in a metal layer (7) overlying the mesa into mutually separate zones (8, 9, 10, 11) of which one zone is a three-armed branching zone (10), to the arms of which the other zones (7, 8, 11) are connected, characterised in that light to be filtered is irradiated through an end face (4111) of one of the zones into this zone in parallel to the substrate surface, and that currents are fed into the individual zones, including the branching zone, via the metal layer (7) overlying the latter, which currents flow through the zones at right angles to the direction of propagation of the light and are smaller than the laser threshold current of the respective zone.

**2.** A process as claimed in Claim 2, characterised in that a current flows through at least one of the zones (8, 9, 11) in the non-conducting direction.

## Revendications

**1.** Procédé d'utilisation d'un élément à semi-conducteur interférométrique (1) comme filtre optique, l'élément à semi-conducteur présentant, intégrée sur un substrat (2) monolithique, une couche guide d'ondes (41) continue, qui forme avec des couches supplémentaires (3, 42, 43) une mésa (4), possède une structure en forme de Y à embranchements contigus, et est subdivisée, par des canaux (44, 45, 46) dans une couche métallique (7) posée sur la mésa, en zones (8, 9, 10, 11) séparées les unes des autres, dont une est une zone d'embranchement (10) à trois branches, aux branches de laquelle sont raccordées les autres zones (7, 8, 11), caractérisé en ce que la lumière à filtrer est irradiée par une surface d'extrémité (4111) d'une des zones, parallèlement à la surface du substrat, dans cette zone, et en ce que sont introduits dans les zones individuelles, y compris la zone d'embranchement, par l'intermédiaire de la couche métallique (7) posée sur elles, des courants qui traversent les zones verticalement par rapport au sens de propagation de la lumière, et qui sont plus faibles que le courant de seuil de l'effet laser de chacune des zones.

**2.** Procédé selon la revendication 1, caractérisé en ce qu'un courant traverse au moins une des zones (8, 9, 10) dans le sens de non conduction.

Fig. 1

Fig. 2